# EUROPEAN PATENT APPLICATION

(11) **EP 3 447 286 A1**
(43) Date of publication of application: **27.02.2019**
(21) Application number: 18186001.6
(22) Date of filing: 27.07.2018
(51) Int. Cl.: F04B 17/00, F04B 45/04, H01L 23/467, H01L 41/04, H01L 41/09

(54) **ENERGY-SAVING CONTROL METHOD OF RESONANT PIEZOELECTRIC AIR PUMP**

(30) Priority: 21.08.2017 TW 10628266
(71) Applicant: Microjet Technology Co., Ltd, Hsinchu (TW)
(72) Inventor: Mou, Hao-Jan, Hsinchu (TW); Chen, Shih-Chang, Hsinchu (TW); Liao, Jia-Yu, Hsinchu (TW); Huang, Chi-Feng, Hsinchu (TW); Lee, Wei-Ming, Hsinchu (TW)
(74) Representative: Uexküll & Stolberg

(57) **Abstract**

An energy-saving control method of a resonant piezoelectric air pump (12) includes steps of: (a) providing the resonant piezoelectric air pump (12) and a control module (11), wherein the resonant piezoelectric air pump (12) and the control module (11) are electrically connected to each other; (b) at the beginning of a unit of time (A), operating the control module (11) to transmit an enable signal to the resonant piezoelectric air pump (12) so that the resonant piezoelectric air pump (12) is driven to transfer an amount of air in a process for air transfer; (c) during the unit of time (A), adjusting a duty ratio of the enable signal by using the control module (11) for enabling or disabling the resonant piezoelectric air pump (12); and (d) after spending the unit of time (A), repeating the step (b) and the step (c) in another unit of time or more units of time thereafter until the process for air transfer is completed.

## Description

### FIELD OF THE INVENTION

The present disclosure relates to an energy-saving control method of a resonant piezoelectric air pump, and more particularly to an energy-saving control method for driving a resonant piezoelectric air pump by adjusting a duty ratio.

### BACKGROUND OF THE INVENTION

With the development of science and technology, air transfer is widely applied in all kinds of electronic devices and medical equipments, and various effects can be achieved by the air transfer. In addition, with the miniaturization and thinning tendency of electronic device and medical equipment, the resonant piezoelectric air pump or the miniature motor is used more widely because of its small size.

In the prior art, the resonant piezoelectric air pump or the miniature motor is driven to transfer the air in an operation without interruption, so as to maximize the amount of the transferred air per unit of time. However, the operation without interruption consumes a lot of power, and the consumed power under the operation without interruption can't result in the most efficient air transfer. Accordingly, there is a need for a solution that enhances the efficiency of air transfer of the resonant piezoelectric air pump or the miniature motor and saves energy at the same time.

Moreover, during the uninterrupted operation of the resonant piezoelectric air pump or the miniature motor, the temperature of the elements therein may be too high. Accordingly, the elements inside the resonant piezoelectric air pump or the miniature motor are broken due to the over-high temperature, the efficiency of air transfer decreases, and the temperature of the outputted air is too high. Accordingly, it is also important to prevent the temperature from getting too high during the air transfer of the resonant piezoelectric air pump or the miniature motor.

Therefore, there is a need for providing an energy-saving control method of a resonant piezoelectric air pump for solving the problems that exists in the prior art relating to inefficient air transfer, large power consumption and over-high temperature caused by the operation without interruption.

### SUMMARY OF THE INVENTION

An object of the present disclosure provides an energy-saving control method of a resonant piezoelectric air pump. By adjusting the duty ratio for driving the resonant piezoelectric air pump, the problems that exists in the prior art relating to inefficient air transfer, large power consumption and over-high temperature caused by the operation without interruption are solved.

In accordance with an aspect of the present disclosure, an energy-saving control method of a resonant piezoelectric air pump is provided. The energy-saving control method includes steps of: (a) providing the resonant piezoelectric air pump and a control module, wherein the resonant piezoelectric air pump and the control module are electrically connected to each other; (b) at the beginning of a unit of time, operating the control module to transmit an enable signal to the resonant piezoelectric air pump so that the resonant piezoelectric air pump is driven to transfer an amount of air in a process for air transfer; (c) during the unit of time, adjusting duty ratio of the enable signal by using the control module for enabling or disabling the resonant piezoelectric air pump; and (d) after spending the unit of time, repeating the step (b) and the step (c) in another unit of time or more units of time thereafter until the process for air transfer is completed.

In accordance with another aspect of the present disclosure, an energy-saving control method of a resonant piezoelectric air pump is provided. The energy-saving control method includes steps of: (a) providing at least one resonant piezoelectric air pump and at least one control module, wherein the resonant piezoelectric air pump and the control module are electrically connected to each other; (b) at the beginning of at least one unit of time, operating the control module to transmit at least one enable signal to the resonant piezoelectric air pump so that the resonant piezoelectric air pump is driven to transfer an amount of air in a process for air transfer; (c) during the unit of time, adjusting a duty ratio of the enable signal by using the control module for enabling or disabling the resonant piezoelectric air pump; and (d) after spending the unit of time, repeating the step (b) and the step (c) in another unit of time or more units of time thereafter until the process for air transfer is completed.

### BRIEF DESCRIPTION OF THE DRAWINGS

FIG. 1A is a schematic view illustrating a resonant piezoelectric air pump and a control module according to an embodiment of the present disclosure;
FIG. 1B is a flowchart illustrating an energy-saving control method of the resonant piezoelectric air pump according to an embodiment of the present disclosure;
FIG. 2A is a schematic graph showing an output signal driving the resonant piezoelectric air pump at 100% duty ratio versus time;
FIG. 2B is a schematic graph showing an output air pressure of driving the resonant piezoelectric air pump at 100% duty ratio versus time;
FIG. 2C is a schematic graph showing an output signal of driving the resonant piezoelectric air pump at a duty ratio according to a first embodiment of the present disclosure versus time;
FIG. 2D is a schematic graph showing an output air pressure of driving the resonant piezoelectric air pump at the duty ratio according to the first embodiment of the present disclosure versus time;
FIG. 2E is a schematic graph showing an output signal of driving the resonant piezoelectric air pump at a duty ratio according to a second embodiment of the present disclosure versus time;
FIG. 3A is a schematic exploded view illustrating a resonant piezoelectric air pump according to an embodiment of the present disclosure;
FIG. 3B is a schematic exploded view illustrating the resonant piezoelectric air pump of FIG. 3A and taken along another viewpoint;
FIG. 4A is a schematic exploded view illustrating the piezoelectric actuator of FIG. 3A;
FIG. 4B is a schematic exploded view illustrating the piezoelectric actuator of FIG. 3A and taken along another viewpoint;
FIG. 4C is a schematic cross-sectional view illustrating the piezoelectric actuator of FIG. 3A; and
FIGS. 5A to 5E schematically illustrate the actions of the resonant piezoelectric air pump of FIG. 3A.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

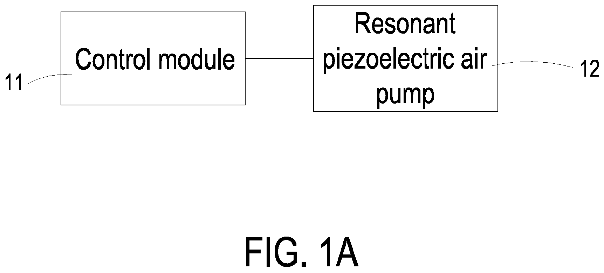

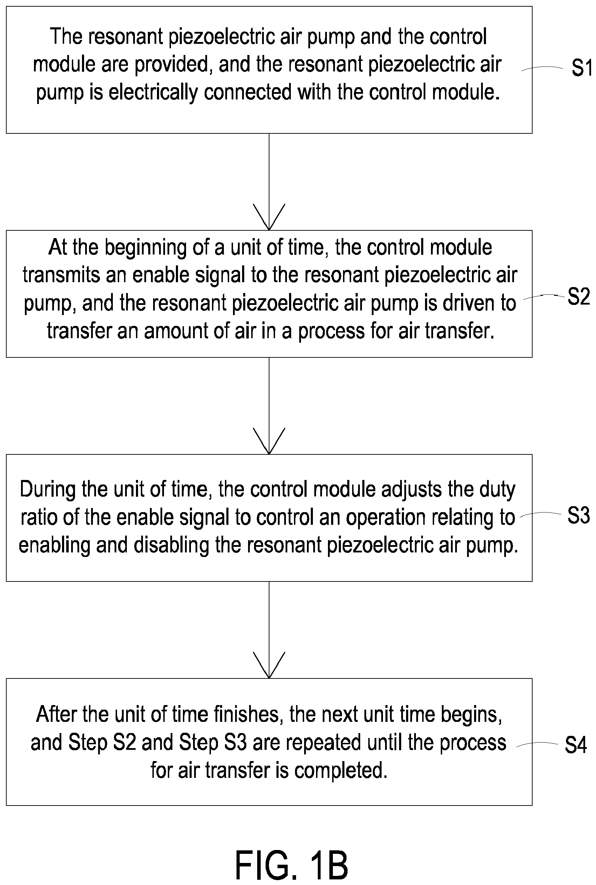

Please refer to FIGS. 1A and 1B. The present disclosure provides an energy-saving control method of a resonant piezoelectric air pump including at least one resonant piezoelectric air pump 12, at least one control module 11, at least one unit of time and at least one enable signal. The number of the resonant piezoelectric air pump 12, the control module 11, the unit of time and the enable signal is exemplified by one for each in the following embodiments but not limited thereto. It is noted that each of the resonant piezoelectric air pump 12, the control module 11, the unit of time and the enable signal can also be provided in plural numbers.

The resonant piezoelectric air pump 12 is a resonance-type piezoelectric air pump for air transfer. The resonant piezoelectric air pump 12 can be applied in all kinds of electronic devices and medical equipments, such as notebook computer, smart phone, smart watch, tablet computer and so on, but not limited thereto. FIG. 1A is a schematic view illustrating a resonant piezoelectric air pump and a control module according to an embodiment of the present disclosure. As shown in FIG. 1A, the resonant piezoelectric air pump 12 is electrically connected to the control module 11. The control module 11 is configured to enable or disable the resonant piezoelectric air pump 12, but not limited thereto. In this embodiment, the control module 11 is connected to a power source (not shown) for providing a driving power to the control module 11. The control module 11 determines whether the driving power is transmitted to the resonant piezoelectric air pump 12, so as to control the on/off operations of the resonant piezoelectric air pump 12.

Please refer to FIGS. 1A and 1B. FIG. 1B is a flowchart illustrating an energy-saving control method of the resonant piezoelectric air pump according to an embodiment of the present disclosure. The energy-saving control method of the resonant piezoelectric air pump achieves energy-saving and efficient air transfer by adjusting the ratio of the enable signal of the resonant piezoelectric air pump 12 in a unit of time (i.e., duty ratio). As shown in FIGS. 1A and 1B, firstly, the resonant piezoelectric air pump 12 and the control module 11 are provided (Step S1). In this embodiment, the resonant piezoelectric air pump 12 is electrically connected to the control module 11, and the control module 11 is configured to enable or disable the resonant piezoelectric air pump 12, but not limited thereto. The detailed structure of the resonant piezoelectric air pump 12 will be further described as follows.

Then, at the beginning of a unit of time, the control module 11 transmits an enable signal to the resonant piezoelectric air pump 12, and the resonant piezoelectric air pump 12 is driven to transfer an amount of air in a process for air transfer (Step S2). In this embodiment, the unit of time is a time interval between two neighboring starting moments of the resonant piezoelectric air pump 12 when being enabled. In other words, from the moment when the resonant piezoelectric air pump 12 is enabled to the moment when the resonant piezoelectric air pump 12 is enabled again subsequently, the time interval therebetween refers to a single unit of time. Preferably but not exclusively, the unit of time has a specific value, which may be varied according to the practical requirements.

During the unit of time, the control module 11 adjusts the duty ratio of the enable signal to control an operation relating to enabling and disabling the resonant piezoelectric air pump 12 until the unit of time ends (Step S3). Namely, the control module 11 adjusts the duty ratio of the enable signal, so as to enable or disable the resonant piezoelectric air pump 12 within the unit of time according to the enable signal. Finally, after the unit of time finishes, the next unit of time begins, and Step S2 and Step S3 are repeated in each unit of time subsequently until the process for air transfer is completed (Step S4).

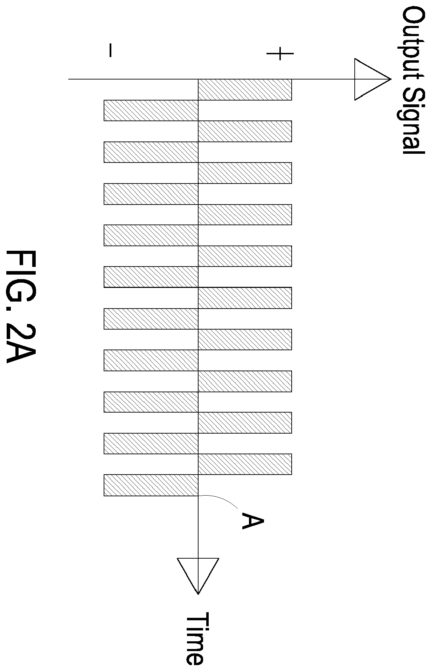

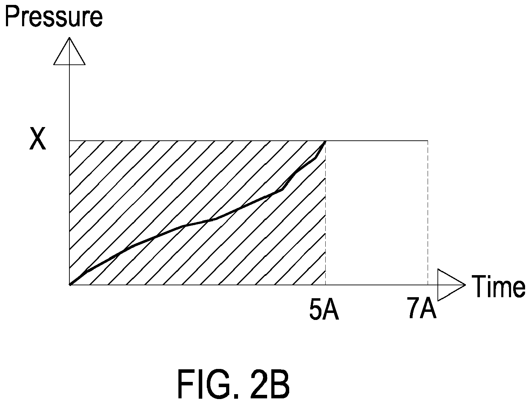

Please refer to FIGS. 2A and 2B. FIG. 2A is a schematic graph showing an output signal of driving the resonant piezoelectric air pump at 100% duty ratio versus time, and FIG. 2B is a schematic graph showing an output air pressure of driving the resonant piezoelectric air pump at 100% duty ratio versus time. As shown in FIG. 2A, the resonant piezoelectric air pump 12 keeps operating without interruption within the unit of time A. That is, the resonant piezoelectric air pump 12 is driven at 100% duty ratio. As shown in FIG. 2B, the resonant piezoelectric air pump 12 driven at 100% duty ratio reaches a specific output air pressure X after five units of time A. The equation for calculating the power consumption (i.e., calculating the shadow area in FIG. 2B) is P_{100%}= X*5A*100%. That is, the power consumption P_{100%} is equal to 5XA.

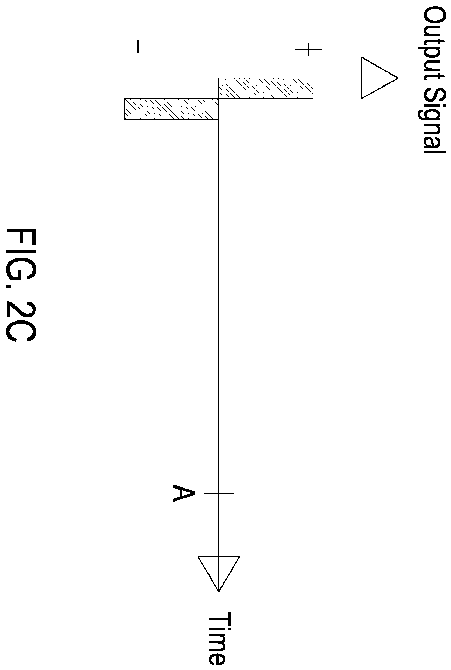

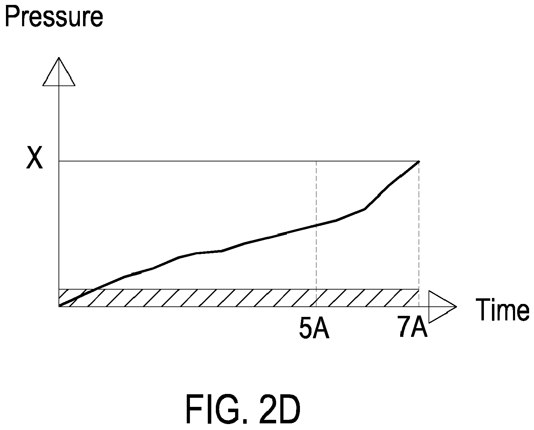

Please refer to FIGS. 2C and 2D. FIG. 2C is a schematic graph showing an output signal of driving the resonant piezoelectric air pump at a duty ratio according to a first embodiment of the present disclosure versus time, and FIG. 2D is a schematic graph showing an output air pressure of driving the resonant piezoelectric air pump at the duty ratio according to the first embodiment of the present disclosure versus time. As shown in FIG. 2C, the resonant piezoelectric air pump 12 according to the first embodiment of the present disclosure starts to operate at the beginning of the unit of time A , and receives the enable signal only during 10% of the unit of time A. That is, the duty ratio of the enable signal for driving the resonant piezoelectric air pump 12 is 10%. However, the duty ratio of the enable signal is not limited thereto, and it may be varied according to the practical requirements. As shown in FIG. 2D, the resonant piezoelectric air pump 12 driven at 10% duty ratio reaches the specific output air pressure X after seven units of time A. The equation for calculating the power consumption (i.e., calculating the shadow area in FIG. 2D) is P_{10%}= X*7A*10%. That is, the power consumption P_{10%} is equal to 0.7XA.

Please refer to FIGS. 2A, 2B, 2C and 2D. As described above, the resonant piezoelectric air pump 12 driven at 100% duty ratio allows the air pressure to accumulate and reach the specific output air pressure X rapidly. However, the resonant piezoelectric air pump 12 consumes a large amount of power (P_{100%}= 5XA) in terms of 100% duty ratio. Compared with 100% duty ratio described above, the resonant piezoelectric air pump 12 at 10% duty ratio takes a longer time to reach the specific output air pressure X. However, the power consumption of the resonant piezoelectric air pump 12 driven at 10% duty ratio (P_{10%}= 0.7XA) is much smaller than the power consumption of the resonant piezoelectric air pump 12 driven at 100% duty ratio (P_{100%}= 5XA). Moreover, during the intermittent operation of the resonant piezoelectric air pump 12 driven at 10% duty ratio, unnecessary power consumption is reduced. Also, the over-high temperature, damage to elements or even reduction in service life of elements, all of which are caused by the continuous operation of the resonant piezoelectric air pump 12, can be avoided. Therefore, the effects of saving energy and efficient air transfer are achieved.

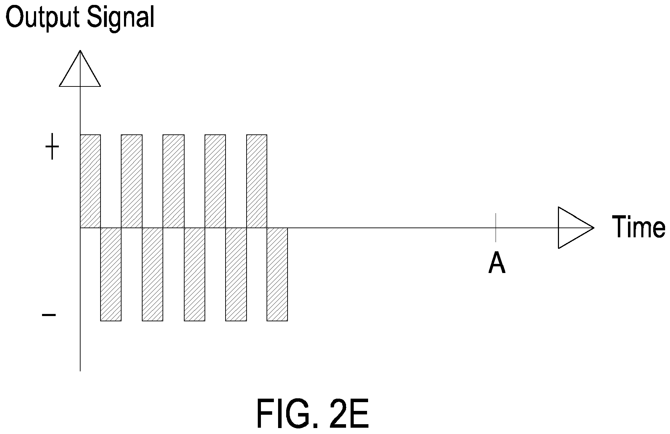

Please refer to FIG. 2E. FIG. 2E is a schematic graph showing an output signal of driving the resonant piezoelectric air pump at a duty ratio according to a second embodiment of the present disclosure versus time. The resonant piezoelectric air pump 12 according to the second embodiment of the present disclosure starts to operate at the beginning of the unit of time A, and receives the enable signal only during 50% of the unit of time A. That is, the duty ratio of the enable signal for driving the resonant piezoelectric air pump 12 is 50%. However, the duty ratio of the enable signal is not limited thereto, and it may be varied according to the practical requirements. In some embodiments, the duty ratio of the enable signal for driving the resonant piezoelectric air pump 12 can be any value between 0.1% and 99%, but is not limited thereto.

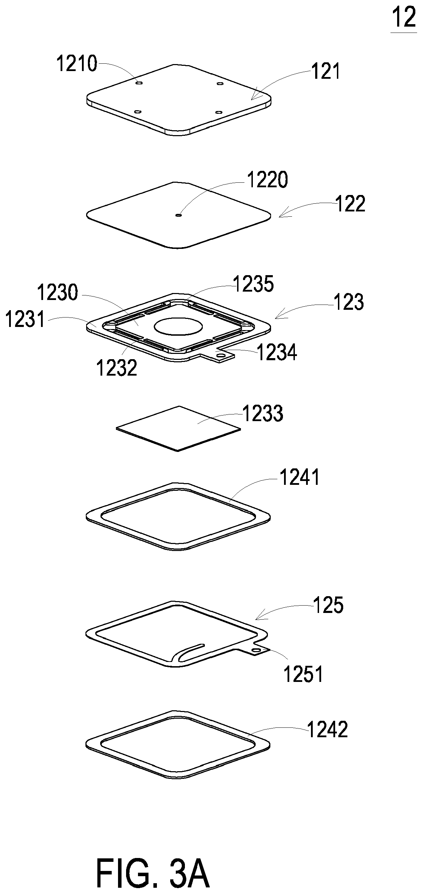

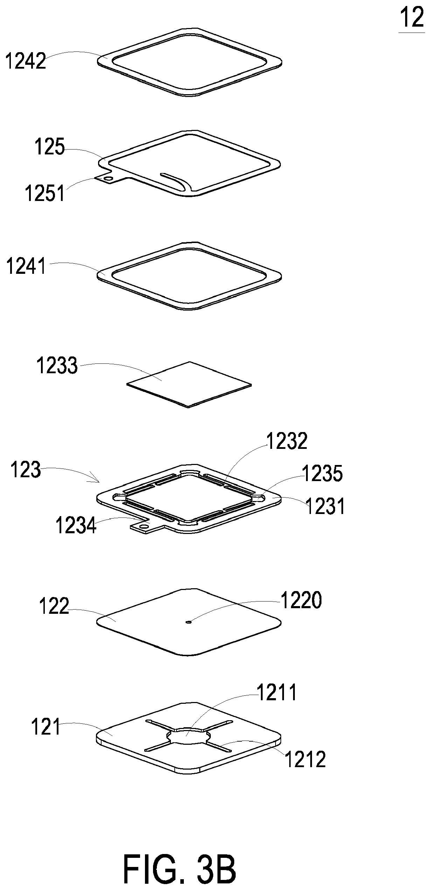

Please refer to FIGS. 3A and 3B. FIG. 3A is a schematic exploded view illustrating a resonant piezoelectric air pump according to an embodiment of the present disclosure, and FIG. 3B is a schematic exploded view illustrating the resonant piezoelectric air pump of FIG. 3A and taken along another viewpoint. The resonant piezoelectric air pump 12 includes an air inlet plate 121, a resonance plate 122, a piezoelectric actuator 123, a first insulation plate 1241, a conducting plate 125 and a second insulation plate 1242. The air inlet plate 121, the resonance plate 122, the piezoelectric actuator 123, the first insulation plate 1241, the conducting plate 125 and the second insulation plate 1242 are stacked on each other sequentially to be assembled together as the resonant piezoelectric air pump 12. In this embodiment, preferably but not exclusively, the piezoelectric actuator 123 is assembled from a suspension plate 1230 and a piezoelectric ceramic plate 1233 and is disposed spatially corresponding to the resonance plate 122. The air is fed from at least one inlet 1210 of the air inlet plate 121 into the resonant piezoelectric air pump 12 and passes through plural pressure chambers by enabling the piezoelectric actuator 123, so as to transfer an amount of air in a process for air transfer.

As shown in FIG. 3A, the air inlet plate 121 of the resonant piezoelectric air pump 12 has at least one inlet 1210. Preferably but not exclusively, the air inlet plate 121 has four inlets 1210, and the number of the inlet 1210 may be varied according to the practical requirements. In response to the action of the atmospheric pressure, the air can be introduced into the resonant piezoelectric air pump 12 through the at least one inlet 1210. As shown in FIG. 3B, a central cavity 1211 and at least one convergence channel 1212 are formed on a bottom surface of the air inlet plate 121, and the bottom surface is opposite to the inlets 1210. In this embodiment, the number of the at least one convergence channel 1212 is four, but not limited thereto. The four convergence channels 1212 are disposed spatially corresponding to the four inlets 1210 on the top surface of the air inlet plate 121 respectively, such that the air entered from the inlet 1210 would be guided along the convergence channels 1212 to the central cavity 1211 and transferred downwardly. Consequently, the air can be transferred by the resonant piezoelectric air pump 12. In this embodiment, the at least one inlet 1210, the at least one convergence channel 1212 and the central cavity 1211 of the air inlet plate 121 are integrally formed from a single structure. The central cavity 1211 is a convergence chamber for temporarily storing the air. In some embodiments, the air inlet plate 131 may be, for example, made of stainless steel. Moreover, the depth of the convergence chamber defined by the central cavity 1211 is equal to the depth of the at least one convergence channel 1212.

In this embodiment, the resonance plate 122 is made of a flexible material, but not limited thereto. The resonance plate 122 includes a central aperture 1220 disposed corresponding to the central cavity 1211 on the bottom surface of the air inlet plate 121 for allowing the air to be transferred downwardly. In other embodiments, the resonance plate 122 may be made of copper.

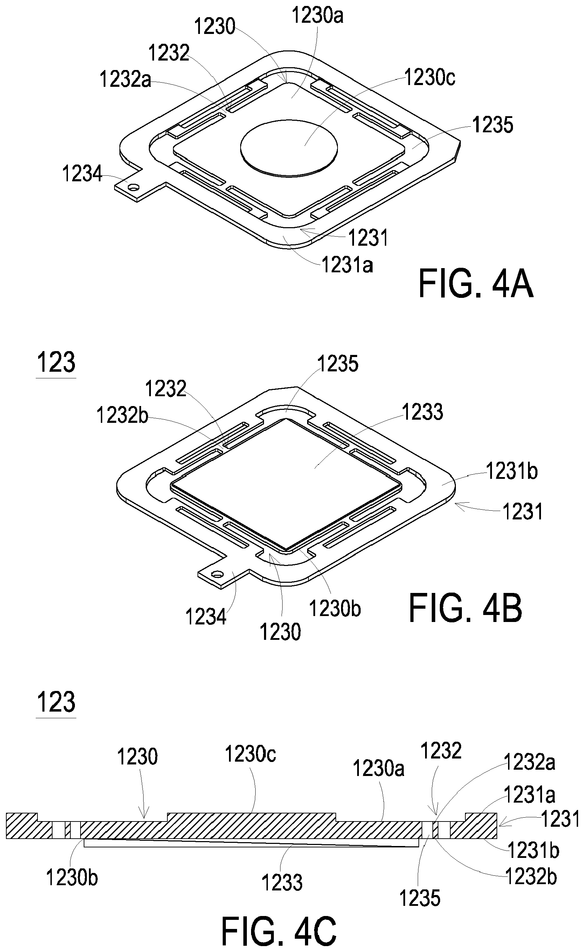

Please refer to FIGS. 4A, 4B and 4C. FIG. 4A is a schematic exploded view illustrating the piezoelectric actuator of FIG. 3A, FIG. 4B is a schematic exploded view illustrating the piezoelectric actuator of FIG. 3A and taken along another viewpoint, and FIG. 4C is a schematic cross-sectional view illustrating the piezoelectric actuator of FIG. 3A. The piezoelectric actuator 123 includes a suspension plate 1230, an outer frame 1231, a plurality of brackets 1232 and a piezoelectric ceramic plate 1233. The piezoelectric ceramic plate 1233 is attached on a bottom surface 1230b of the suspension plate 1230. The plural brackets 1232 are connected between the suspension plate 1230 and the outer frame 1231. While in each bracket 1232, two ends of the bracket 1232 are connected to the outer frame 1231, and another end of the bracket 1232 is connected to the suspension plate 1230. A plurality of vacant spaces 1235 are formed among the bracket 1232, the suspension plate 1230 and the outer frame 1231 so that the air can go through the vacant spaces 1235. The disposing way and type of the suspension plate 1230, the outer frame 1231 and the brackets 1232 and the number of the brackets 1232 may be varied according to the practical requirements. Moreover, a conducting pin 1234 is protruded outwardly from the outer frame 1231 so as to be electrically connected to an external circuit (not shown).

The suspension plate 1230 has a bulge 1230c that makes the suspension plate 1230 a stepped structure. The bulge 1230c is formed on a top surface 1230a of the suspension plate 1230. The bulge 1230c is for example but not limited to a circular convex structure. As shown in FIGS. 4A, 4B and 4C, a top surface of the bulge 1230c of the suspension plate 1230 is coplanar with a top surface 1231a of the outer frame 1231, while the top surface 1230a of the suspension plate 1230 is coplanar with a top surface 1232a of the bracket 1232. Moreover, there is a drop of specified amount from the bulge 1230c of the suspension plate 1230 (or the top surface 1231a of the outer frame 1231) to the top surface 1230a of the suspension plate 1230 (or the top surface 1232a of the bracket 1232). With regard to the bottom surface 1230b of the suspension plate 1230, as shown in FIGS. 4B and 4C, the bottom surface 1230b, a bottom surface 1231b of the outer frame 1231 and a bottom surface 1232b of the bracket 1232 are coplanar with each other. The piezoelectric ceramic plate 1233 is attached on the bottom surface 1230b of the suspension plate 1230. In some embodiments, the suspension plate 1230, the plural brackets 1232 and the outer frame 1231 are integrally formed from a metal plate (e.g., a stainless steel plate).

Please refer to FIGS. 3A and 3B. The resonant piezoelectric air pump 12 has the first insulation plate 1241, the conducting plate 125 and the second insulation plate 1242, which are stacked on each other sequentially and located under the piezoelectric actuator 123. The profiles of the first insulation plate 1241, the conducting plate 125 and the second insulation plate 1242 substantially match the profile of the outer frame 1231 of the piezoelectric actuator 123. The first insulation plate 1241 and the second insulation plate 1242 are made of insulating materials (e.g. plastic material) for providing insulating efficacy. The conducting plate 125 is made of an electrically conductive material (e.g. a metallic material) for providing electrically conducting efficacy. Moreover, the conducting plate 125 has a conducting pin 1251 so as to be electrically connected to an external circuit (not shown).

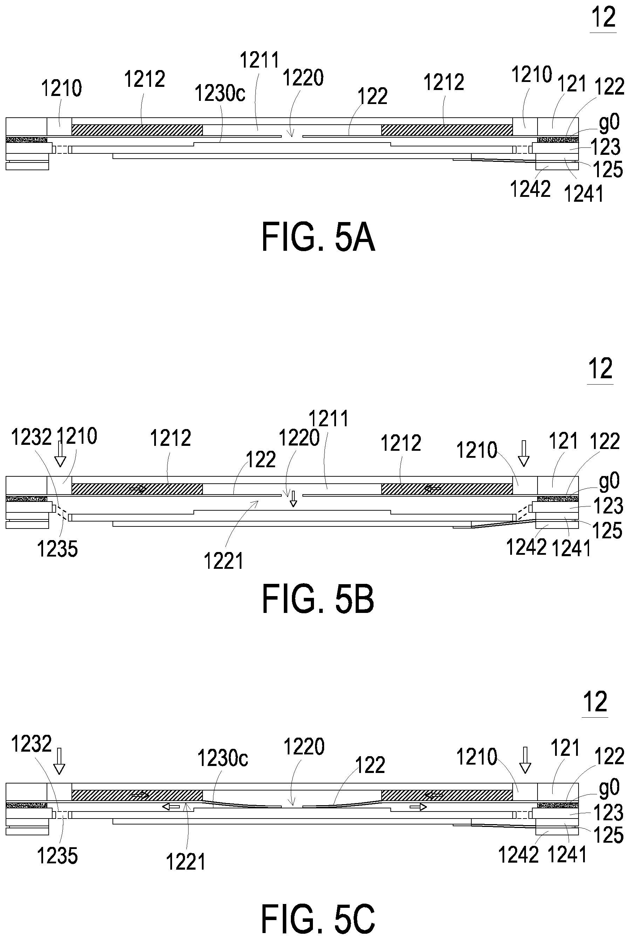

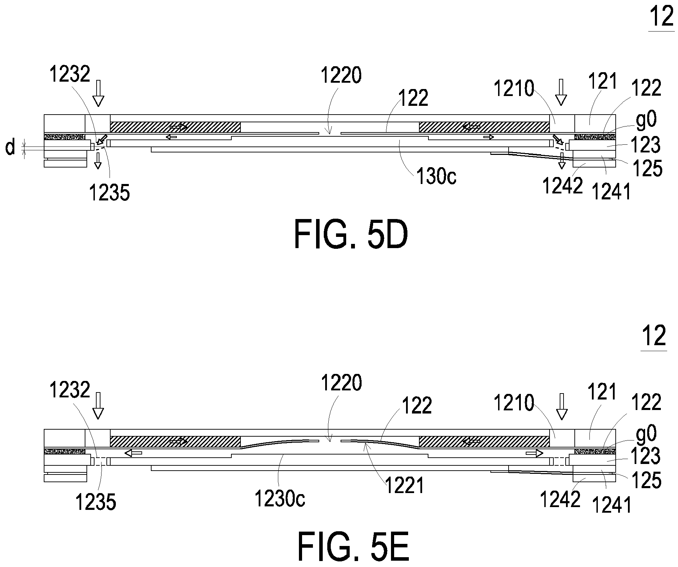

Please refer to FIGS. 3A, 3B, 5A, 5B, 5C, 5D and 5E. FIGS. 5A to 5E schematically illustrate the actions of the resonant piezoelectric air pump of FIG. 3A. As shown in FIG. 5A, the air inlet plate 121, the resonance plate 122, the piezoelectric actuator 123, the first insulation plate 1241, the conducting plate 125 and the second insulation plate 1242 of the resonant piezoelectric air pump 12 are stacked on each other sequentially. Moreover, there is a gap g0 between the resonance plate 122 and the outer frame 1231 of the piezoelectric actuator 123, which is formed and maintained by a filler (e.g. a conductive adhesive) inserted therein in this embodiment. The gap g0 ensures the proper distance between the resonance plate 122 and the bulge 1230c of the suspension plate 1230 of the piezoelectric actuator 123, so that the air can be transferred quickly, the contact interference is reduced and the generated noise is largely reduced. In some embodiments, the height of the outer frame 1231 of the piezoelectric actuator 123 is increased, so that the gap is formed between the resonance plate 122 and the piezoelectric actuator 123.

As shown in FIGS. 5A to 5E, after the air inlet plate 121, the resonance plate 122 and the piezoelectric actuator 123 are combined together, the convergence chamber for converging the air is further defined by the central aperture 1220 of the resonance plate 122 and the central cavity 1211 of the air inlet plate 121 collaboratively. Moreover, a first chamber 1221 is formed between the resonance plate 122 and the piezoelectric actuator 123 for temporarily storing the air. Through the central aperture 1220 of the resonance plate 122, the first chamber 1221 is in communication with the convergence chamber formed within the central cavity 1211 on the bottom surface of the air inlet plate 121. The air in the peripheral regions of the first chamber 1221 can be discharged through the vacant space 1235 between the brackets 1232 of the piezoelectric actuator 123.

In this embodiment, when the resonant piezoelectric air pump 12 is enabled, the piezoelectric actuator 123 vibrates along a vertical direction in a reciprocating manner by using the bracket 1232 as a fulcrum. As shown in FIG. 5B, when the piezoelectric actuator 123 vibrates downwardly in response to the applied voltage, the air is fed from the at least one inlet 1210 of the air inlet plate 121 and converged to the central cavity 1211 along the at least one convergence channel 1212 on the bottom surface of the air inlet plate 121. Then, the air is transferred through the central aperture 1220 of the resonance plate 122 which is disposed corresponding to the central cavity 1211, and introduced downwardly into the first chamber 1221. Afterwards, being driven by the vibration of the piezoelectric actuator 123, the resonance plate 122 is in resonance with the piezoelectric actuator 123 and thus the resonance plate 122 also vibrates vertically in a reciprocating manner.

As shown in FIG. 5C, when the resonance plate 122 vibrates downwardly, the resonance plate 122 moves down to contact and attach on the bulge 1230c of the suspension plate 1230 of the piezoelectric actuator 123. Owing to the deformation of the resonance plate 122 described above, a middle communication space of the first chamber 1221 is closed, and the volume of the first chamber 1221 is compressed. Under this circumstance, the pressure gradient occurs to push the air in the first chamber 1221 moving toward peripheral regions of the first chamber 1221 and flowing downwardly through the vacant space 1235 of the piezoelectric actuator 123.

FIG. 5D shows that the resonance plate 122 returns to its original position. The piezoelectric actuator 123 driven by the applied voltage vibrates upwardly with a displacement d. In that case, the volume of the first chamber 1221 is continuously compressed to generate the pressure gradient which makes the air in the first chamber 1221 continuously pushed toward peripheral regions. Meanwhile, the external ambient air is continuously fed into the at least one inlet 1210 of the air inlet plate 121, and transferred to the convergence chamber formed within the central cavity 1211.

Then, as shown FIG. 5E, influenced by the upward motion of the piezoelectric actuator 123, the resonance plate 122 moves upwardly in resonance with the piezoelectric actuator 123. Consequently, the air is introduced into the first chamber 1221 through the central aperture 1220 of the resonance plate 122, moves downwardly and discharged from the resonant piezoelectric air pump 12 through the vacant space 1235 between the brackets 1232 of the piezoelectric actuator 123. Consequently, a pressure gradient is generated in the designed fluid channels of the resonant piezoelectric air pump 12 to facilitate the air to flow at a high speed. Moreover, since there is an impedance difference between the feeding direction and the exiting direction, the air can be transferred from the inlet side to the outlet side. Even if a gas pressure exists at the outlet side, the resonant piezoelectric air pump 12 still has the capability of pushing the air to the fluid channels as well as achieving the silent efficacy. In some embodiments, the vibration frequency of the vertical reciprocation of the resonance plate 122 is equal to the vibration frequency of the piezoelectric actuator 123. That is, the resonance plate 122 and the piezoelectric actuator 123 move upwardly or downwardly at the same time. In fact, the vibration frequencies thereof can be varied according to the practical requirements, but not limited to the actions shown in the embodiments of the present disclosure.

In addition, the unit of time described above is for example but not limited to 1 second. Moreover, the frequency of the enable signal is between 20 KHz and 28 KHz. The frequency of the enable signal is exemplified by 28 KHz and further described below. When the duty ratio is 100%, the enable signal drives the piezoelectric actuator 123 to operate 28000 times per second. When the duty ratio is 10%, the enable signal drives the piezoelectric actuator 123 to operate 2800 times per second. When the duty ratio is 0.1%, the enable signal drives the piezoelectric actuator 123 to operate 28 times per second. In other embodiments, the unit of time may be 0.5 seconds but not limited thereto.

From the above descriptions, the present disclosure provides an energy-saving control method of a resonant piezoelectric air pump. By the control module, the duty ratio of the enable signal for driving the resonant piezoelectric air pump is adjusted, thus the power consumption is reduced. Moreover, the over-high temperature, damage to elements or even reduction in service life of elements, all of which are caused by the continuous operation of the resonant piezoelectric air pump, can be avoided. Therefore, the effects of saving energy and efficient air transfer are achieved.

While the disclosure has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. An energy-saving control method of a resonant piezoelectric air pump (12), comprising steps of:
(a) providing the resonant piezoelectric air pump (12) and a control module (11), wherein the resonant piezoelectric air pump (12) and the control module (11) are electrically connected to each other;
(b) at the beginning of a unit of time (A), operating the control module (11) to transmit an enable signal to the resonant piezoelectric air pump (12) so that the resonant piezoelectric air pump (12) is driven to transfer an amount of air in a process for air transfer;
(c) during the unit of time (A), adjusting a duty ratio of the enable signal by using the control module (11) for enabling or disabling the resonant piezoelectric air pump (12); and
(d) after spending the unit of time (A), repeating the step (b) and the step (c) in another unit of time or more units of time thereafter until the process for air transfer is completed.

2. The energy-saving control method of the resonant piezoelectric air pump (12) according to claim 1, wherein the duty ratio of the enable signal is between 0.1% and 99%.

3. The energy-saving control method of the resonant piezoelectric air pump (12) according to claim 2, wherein the duty ratio of the enable signal is 10%.

4. The energy-saving control method of the resonant piezoelectric air pump (12) according to claim 2, wherein the duty ratio of the enable signal is 50%.

5. The energy-saving control method of the resonant piezoelectric air pump (12) according to claim 2, wherein the unit of time (A) is 1 second.

6. The energy-saving control method of the resonant piezoelectric air pump (12) according to claim 2, wherein the unit of time (A) is 0.5 seconds.

7. The energy-saving control method of the resonant piezoelectric air pump (12) according to claim 2, wherein the duty ratio of the enable signal is 0.1%.

8. The energy-saving control method of the resonant piezoelectric air pump (12) according to claim 7, wherein a frequency of the enable signal is between 20 KHz and 28 KHz.

9. The energy-saving control method of the resonant piezoelectric air pump (12) according to claim 7, wherein the frequency of the enable signal is 28 KHz.

10. The energy-saving control method of the resonant piezoelectric air pump (12) according to claim 1, wherein the resonant piezoelectric air pump (12) comprises:
an air inlet plate (121) having at least one inlet (1210), at least one convergence channel (1212) and a central cavity (1211), wherein the at least one convergence channel (1212) spatially corresponds to the at least one inlet (1210) and guides air from the inlet (1210) to converge to the central cavity (1211);
a resonance plate (122) having a central aperture (1220), wherein the central aperture (1220) is spatially corresponding to the central cavity (1211);
a piezoelectric actuator (123) having a suspension plate (1230), an outer frame (1231), a plurality of brackets (1232) and a piezoelectric ceramic plate (1233), wherein the plurality of brackets (1232) are connected between the suspension plate (1230) and the outer frame (1231), and the piezoelectric ceramic plate (1233) is attached on a surface (1230b) of the suspension plate (1230);
at least one insulation plate (1241, 1242); and
a conducting plate (125),
wherein the air inlet plate (121), the resonance plate (122), the piezoelectric actuator (123), the at least one insulation plate (1241, 1242) and the conducting plate (125) are stacked sequentially to be assembled together as the resonant piezoelectric air pump (12), and a first chamber (1221) is defined by a gap (g0) between the resonance plate (122) and the piezoelectric actuator (123).

11. The energy-saving control method of the resonant piezoelectric air pump (12) according to claim 10, wherein the step (b) of the energy-saving control method further comprises a step of:
(b1) vibrating the piezoelectric actuator (123) in a downward direction by enabling the resonant piezoelectric air pump (12), wherein the air is inhaled from the at least one inlet (1210) of the air inlet plate (121), converged to the central cavity (1211) along the at least one convergence channel (1212) and flows in the downward direction into the first chamber (1221) through the central aperture (1220) of the resonance plate (122).

12. The energy-saving control method of the resonant piezoelectric air pump (12) according to claim 11, wherein the step (b) of the energy-saving control method further comprises a step of:
(b2) vibrating the resonance plate (122) in the downward direction in resonance with the piezoelectric actuator (123), wherein the resonance plate (122) moves away from an original position and attaches to the suspension plate (1230) of the piezoelectric actuator (123), and the volume of the first chamber (1221) is compressed, thereby pushing the air to move toward the peripheral regions of the first chamber (1221) and flow downwardly through a vacant space (1235) between the brackets (1232) of the piezoelectric actuator (123).

13. The energy-saving control method of the resonant piezoelectric air pump (12) according to claim 12, wherein the step (b) of the energy-saving control method further comprises a step of:
(b3) vibrating the piezoelectric actuator (123) in an upward direction when the resonance plate (122) returns to the original position, wherein the volume of the first chamber (1221) is compressed which makes the air flow toward the peripheral regions of the first chamber (1221) and the air outside the resonant piezoelectric air pump (12) is continuously inhaled from the at least one inlet (1210) of the air inlet plate (121) and then converged to the central cavity (1211).

14. The energy-saving control method of the resonant piezoelectric air pump (12) according to claim 13, wherein the step (b) of the energy-saving control method further comprises steps of:
(b4) vibrating the resonance plate (122) in the upward direction in resonance with the piezoelectric actuator (123), wherein the air in the central cavity (1211) is introduced into the first chamber (1221) through the central aperture (1220) of the resonance plate (122), and the air moves in the downward direction and passes through the vacant space (1235) between the brackets (1232) of the piezoelectric actuator (123); and
(b5) repeating the step (b1), the step (b2), the step (b3) and the step (b4) for transferring the air continuously.

15. An energy-saving control method of a resonant piezoelectric air pump (12), comprising steps of:
(a) providing at least one resonant piezoelectric air pump (12) and at least one control module (11), wherein the resonant piezoelectric air pump (12) and the control module (11) are electrically connected to each other;
(b) at the beginning of a unit of time (A), operating the control module (11) to transmit at least one enable signal to the resonant piezoelectric air pump (12) so that the resonant piezoelectric air pump (12) is driven to transfer an amount of air in a process for air transfer;
(c) during the unit of time (A), adjusting a duty ratio of the enable signal by using the control module (11) for enabling or disabling the resonant piezoelectric air pump (12); and
(d) after spending the unit of time (A), repeating the step (b) and the step (c) in another unit of time or more units of time thereafter until the process for air transfer is completed.
